# EUROPEAN PATENT APPLICATION

(11) **EP 4 622 233 A1**
(43) Date of publication of application: **24.09.2025**
(21) Application number: 25164754.1
(22) Date of filing: 19.03.2025
(51) Int. Cl.: H04M 9/08

(54) **WIRED/WIRELESS TRANSCEIVER AND METHOD FOR LINE ECHO CANCELLATION**

(30) Priority: 21.03.2024 KR 20240039005
(71) Applicant: Z. Tec. Co. Ltd, Gyeongsangbuk-do 740-872 (KR)
(72) Inventor: HAN, Ki Leong, 10898 Paju-si, Gyeonggi-do (KR); CHOUN, Sea Myung, 10354 Goyang-si, Gyeonggi-do (KR); SHIN, Seung Won, 21015 Incheon (KR); KIM, Wan Tae, 16519 Suwon-si, Gyeonggi-do (KR)
(74) Representative: Samson & Partner Patentanwälte mbB

(57) **Abstract**

Disclosed are a wired/wireless transceiver and a method for line echo cancellation that can select a wired or wireless manner according to the convenience and surrounding environment of a target user, transmit and receive a voice signal to/from a different user, cancel a line echo component of the target user included in a voice signal of the different user, generate a side tone of the target user, and provide the side tone to the target user in a preset time.

## Description

### BACKGROUND

### 1. Technical Field

The present disclosure relates to a wired/wireless transceiver, and particularly, to a wired/wireless transceiver and a method for line echo cancellation that can transmit/receive signals by wire in a wired area, wirelessly transmit/receive signals in a certain range in a non-wired area, cancel a line echo component of a target user included in a voice signal of a different user, generate a side tone of the target user, and provide the side tone to the target user in a preset time.

### 2. Related Art

An intercom refers to an inter communication system that enables direct communication without a separate exchanger in a certain area. For example, the intercom can be installed for general industrial purposes for the purpose of instructions or usual communication between a studio and a control room or between control rooms, and can be installed at various types of combat vehicles including mechanized vehicles for military purposes.

The current streamlined communication device installed in a mechanized vehicle includes a helmet worn by a crew member and a control device attached to the interior wall of the vehicle. The communication device in which functional blocks are connected by wires has a complicated wiring connection inside the mechanized vehicle, and an adverse influence of the weight of the wires on the crew member is not ignorable. In addition, the streamlined communication device installed in the mechanized vehicle has the disadvantage that the interior of the vehicle is not controllable when the crew member leaves the vehicle. For example, some crew members of the mechanized vehicle are not communicable with crew members located inside the mechanized vehicle from outside the mechanized vehicle.

In order to resolve such disadvantage, a technology (Publication Patent No. 10-2020-0027853) that replaces a streamlined communication device with a wireless one has been proposed. The proposed technology includes a vehicle radio that transmits and receives signals to/from an external combat radio network through a wireless network, a main controller connected to the vehicle radio by wire, and a headset.

In the proposed technology, a small communication device including a main controller and a headset is connected wirelessly, and only pre-registered devices can access wirelessly through a mutual registration process between devices, and a small communication device inside a mechanized vehicle is designed to communicate by specifying a combat radio network outside the mechanized vehicle through the main controller. In particular, when a tank commander is located outside the mechanized vehicle, the small communication device is designed to be able to communicate wirelessly with crew members inside the mechanized vehicle within a certain distance from the mechanized vehicle. The proposed technology has a characteristic of having a full duplexer structure by applying a communication protocol stack based on digital enhanced cordless telecommunications (DECT) in order to solve the inconvenience of the existing wired communication sets.

However, in order to accurately confirm and perform instructions and controls in the mechanized vehicle, an instruction person needs to input instruction voice into a microphone and then the instruction voice needs to be fedback to the instruction person within 40 ms (milliseconds) so that the instruction voice can be confirmed by the ear of the instruction person, which is called side tone, but the proposed technology does not provide specific suggestions for such a technology.

In addition, a voice signal transmitted from a different crew member is affected by a voice signal transmitted by a receiving crew member, and therefore, there is no specific description of a technology for cancelling a voice signal component of the receiving crew member included in the voice signal transmitted from the different crew member.

### SUMMARY

Various embodiments are directed to providing a wired/wireless transceiver that can select a wired or wireless manner according to the convenience and surrounding environment of a target user, transmit and receive a voice signal to/from a different user, cancel a line echo component of the target user included in a voice signal of the different user, generate a side tone of the target user, and provide the side tone to the target user in a preset time.

Various embodiments are directed to providing a method for cancelling line echo being a voice side tone of a target user included in a voice signal of a different user transmitted to the target user.

Technical problems to be achieved in the present disclosure are not limited to the aforementioned technical problems and the other unmentioned technical problems will be clearly understood by those skilled in the art to which the present disclosure pertains from the following description.

In order to solve the above technical problem, a wired/wireless transceiver according to the present disclosure is connected to an intercom communication controller in a wireless manner and connected to a voice signal input/output device in a wired manner, transmits/receives voice signals of a target user and a different user between the intercom communication controller and the voice signal input/output device, generates a side tone corresponding to the voice signal of the target user applied to the voice signal input/output device, transmits the generated side tone to the voice signal input/output device, cancels a line echo component included in the voice signal of the different user applied from the intercom communication controller and caused by the voice signal of the target user, and outputs the signal with no line echo component to the voice signal input/output device.

In order to solve the above another technical problem, a method for line echo cancellation according to the present disclosure includes receiving voice signals of a different user and a target user; generating a first synthetic voice by synthesizing an inverted voice **A̅,** in which a phase of voice A being the voice signal of the target user is inverted, with voice B being the voice signal of the different user; deriving a boundary value by comparing the first synthetic voice with the voice A, generating a plurality of synthetic voices by adding the inverted voice **A̅** to the first synthetic voice and accumulating the added voice, deriving a plurality of boundary values by comparing the plurality of synthetic voices with the voice A, respectively, and deriving an optimal voice signal by performing the generation of the synthetic voice and the derivation of the boundary value until the derived boundary value is identical to an optimal boundary value specified in advance.

Technical problems to be achieved in the present disclosure are not limited to the aforementioned technical problems and the other unmentioned technical problems will be clearly understood by those skilled in the art to which the present disclosure pertains from the following description.

A wired/wireless transceiver and a method for line echo cancellation according to the present disclosure described above have the advantage of transmitting/receiving signals by wire in a wired area, wirelessly transmitting/receiving signals in a non-wired area, cancelling a voice side tone of a target user included in a voice signal of a different user, and providing the side tone of the target user to the tarter user in a preset time, thereby clearly and definitely transmitting/receiving a voice signal when the wired/wireless transceiver is used wirelessly and allowing the target user to exactly confirm a voice signal input by the target user to a microphone.

Effects achievable in the disclosure are not limited to the aforementioned effects and the other unmentioned effects will be clearly understood by those skilled in the art from the following description.

### BRIEF DESCRIPTION OF THE DRAWINGS

FIG. 1 illustrates operation conditions of a wired/wireless transceiver according to the present disclosure.
FIG. 2 illustrates an example of an internal configuration of the wired/wireless transceiver according to the present disclosure.
FIG. 3 illustrates a signal processing flow chart for performing a method for line echo cancellation according to the present disclosure.
FIG. 4 illustrates a specific embodiment of a step of searching for an optimal voice signal.
FIG. 5 illustrates a photograph of a product in which the wired/wireless transceiver according to the present disclosure is actually applied to a headset.

### DETAILED DESCRIPTION

In order to fully understand the present disclosure, advantages in operation of the present disclosure, and objects achieved by carrying out the present disclosure, the accompanying drawings for explaining exemplary examples of the present disclosure and the contents described with reference to the accompanying drawings need to be referred to.

Hereinafter, preferred embodiments of the present disclosure are described in detail with reference to the accompanying drawings. The same reference numerals among the reference numerals in each drawing indicate the same members.

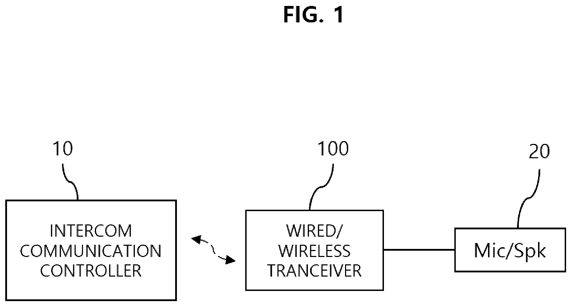

FIG. 1 illustrates operation conditions of a wired/wireless transceiver 100 according to the present disclosure.

Referring to FIG. 1, it can be seen that the wired/wireless transceiver 100 according to the present disclosure is responsible for transmitting and receiving voice signals between an intercom communication controller 10 and a voice signal input/output device 20. The intercom communication controller 10, the wired/wireless transceiver 100, and the voice signal input/output device 20 can be components within a certain area where intercom is possible.

The intercom communication controller 10 can refer to a means that can perform wired/wireless communication with a main controller (not illustrated) within an intercom communication area, or perform wired/wireless communication with other communication controllers outside the intercom communication area.

The voice signal input/output device 20 may include, for example, a microphone and earphones or a microphone and a speaker.

FIG. 1 illustrates that the wired/wireless transceiver 100 and the intercom communication controller 10 can be connected in a wired manner and a wireless manner and the wired/wireless transceiver 100 and the voice signal input/output device 20 are connected in a wired manner. However, an embodiment in which the wired/wireless transceiver 100 can transmit and receive voice signals to/from the intercom communication controller 10 and the voice signal input/output device 20 in a wired manner and a wireless manner is also possible.

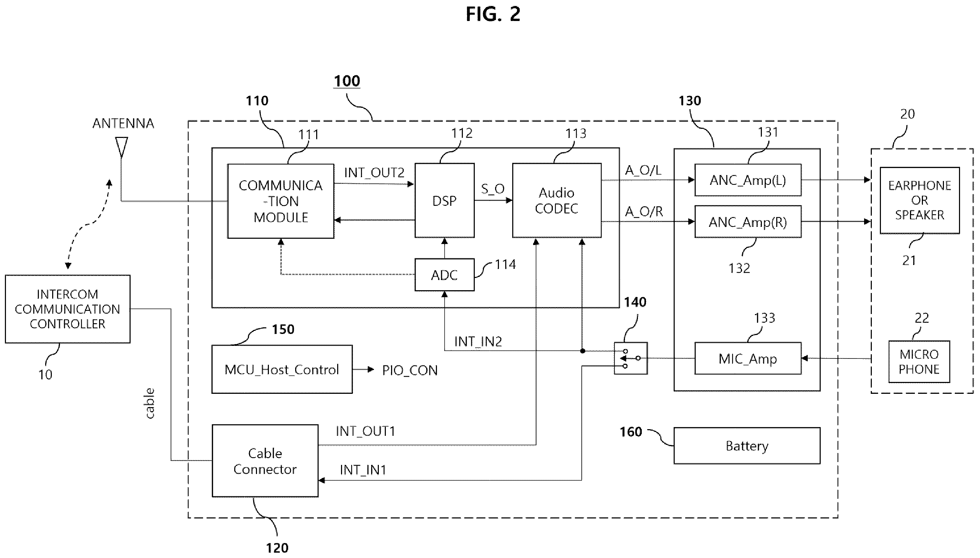

FIG. 2 illustrates an example of an internal configuration of the wired/wireless transceiver 100 according to the present disclosure.

Referring to FIG. 2, the wired/wireless transceiver 100 includes a wireless transceiving unit 110, a wired transceiving unit (Cable Connector) 120, an input/output amplification unit 130, a transmission path selection means 140, a controller (MCU_Host_Control) 150, and a battery (Battery) 160.

In the following description, a user who carries and directly uses the wired/wireless transceiver 100 according to the present disclosure is assumed to be a target user, and a user who transmits and receives voice signals to/from the target user is assumed to be a different user. In addition, the different user may be a different user within an intercom communication area, but may also be a different user outside the intercom communication area.

The input/output amplification unit 130 includes two amplifiers ANC_Amp(L) and ANC_Amp(R) that amplify voice signals corresponding to voice signals INT_OUT1 and INT_OUT2 of the different user to be transmitted to an earphone or speaker 21 of the target user and an amplifier MIC_Amp that amplifies a voice signal of the target user input to the microphone 22. Here, L and R represent left L and right R, respectively, and represent that the voice signals are separately transmitted to two earphones or two speakers.

The ANC (Active Noise Cancellation) used in the name of the amplifier includes the meaning that the three amplifiers 131 to 133 perform a function of canceling noises coming from the earphone or speaker 21 and the microphone 22.

The transmission path selection means 140 transmits voice signals INT_IN applied by the target user through the microphone 22 to a selected one of the transceiving unit 110 and the Cable Connector 120. The voice signal path is selected according to an instruction of the MCU_Host_Control 150 to be described below. In the following description, it is assumed that a voice signal transmitted to the wireless transceiving unit 110 among the voice signals INT_IN applied by the target user through the microphone 22 is INT_IN2, and a voice signal transmitted to the Cable Connector 120 is INT_IN1.

The wireless transceiving unit 110 includes a communication module 111, a digital signal processing device (DSP) 112, an audio codec (Audio CODEC) 113, and an analog digital convertor (ADC) 114 that generate the side tone of the target user in response to a voice signal of the different user applied through the intercom communication controller 10 and a voice signal of the target user applied through the transmission path selection means 140, and generate a pure voice signal of the different user by cancelling a line echo component of the target user from the voice signal of the different user.

The communication module 111 is a module that wirelessly communicates with the intercom communication controller 10, and may include, for example, a Bluetooth communication module. When a Bluetooth communication module is used, the following conditions need to be satisfied.

For 79 channels in the Bluetooth frequency band of 2,402 MHz to 2,480 MHz, the average transmission output of a start frequency CH0 (2402 MHz), a middle frequency CH39 (2441 MHz), and an end frequency CH78 (2480 MHz) needs to be 4 dBm or more, and a wireless channel deviation per output needs to be ±75 KHz or less. The reception sensitivity needs to be -70 dBm or more based on a Bluetooth bit error rate (BER) of 0.1% or less.

The communication module 111 may further include an antenna used for wireless communication with the intercom communication controller 10, and receives the voice signal of the different user passing through the intercom communication controller 10 and the antenna.

The ADC 114 converts the voice signal INT_IN2 of the target user in analog form, which is applied through the transmission path selection means 140, into a digital signal, and provides the digital signal to the DSP 112. The output of the ADC 114 can be directly applied to the communication module 111 in order to test the operation characteristics of the communication module 111.

The DSP 112 processes the voice signal INT_IN2 of the target user converted into the digital signal by the ADC 114, and transmits the processed signal to the intercom communication controller 10 via the communication module 111, or cancels the voice signal INT_IN2 component of the target user included in the voice signal INT_OUT2 of the different user, that is, a line echo component, by using the voice signal INT_OUT2 of the different user applied via the communication module 111 and the voice signal INT_IN2 of the target user converted into the digital signal by the ADC 114, and then transmits the pure voice signal S_O of the different user to the Audio CODEC 113. The line echo component means a component of the voice signal that is input to the microphone 22 by the target user and is reflected and returned.

In order to perform the above function, the DSP 112 stores the voice signal INT_IN2 of the target user converted into the digital signal by the ADC 114, generates an inverted voice signal INT_IN2B of the target user by inverting the phase of the voice signal INT_IN2 of the target user, generates a delayed inverted voice signal INT_IN2B_D of the target user by delaying the inverted voice signal INT_IN2B of the target user for synchronization with the voice signal INT_OUT2 of the different user applied through the communication module 111, and generates the pure voice signal S_O of the different user, which is a signal from which the line echo component being the voice signal component of the target user included in the voice signal INT_OUT2 of the different user has been cancelled, by using the voice signal INT_OUT2 of the different user, the delayed inverted voice signal INT_IN2B_D of the target user, the voice signal INT_IN2 of the target user, and the inverted voice signal INT_IN2B of the target user.

The voice signal INT_OUT2 of the different user received by the wireless transceiving unit 110 is a mixture of the actual voice signal of the different user and the voice signal (line echo component) of the target user. Therefore, in order to accurately recognize the voice signal of the different user, the voice signal of the target user needs to be cancelled from the voice signal INT_OUT2 of the different user received by the wireless transceiving unit 110, and as described above, the DSP 112 performs such a function.

On the other hand, the Audio CODEC 113 generates a side tone by using the voice signal INT_IN2 of the target user applied through the transmission path selection means 140 and transmits the generated side tone to the input/output amplification unit 130. On the other hand, the Audio CODEC 113 processes the pure voice signal S_O of the different user output from the DSP 112 and the voice signal INT_OUT1 of the different user applied through the Cable Connector 120, and transmits the processed signal to the input/output amplification unit 130.

Two audio output signals A_O/L and A_O/R output from the Audio CODEC 113 are signals obtained by processing the side tone of the target user, the voice signal INT_OUT1 of the different user, and the pure voice signal S_O of the different user, and can be transmitted to earphones or two speakers worn on both ears of the target user, respectively.

In order for the target user to confirm whether the content transmitted to the microphone 22 is the content to be actually transmitted by the target user, the voice signal transmitted to the microphone 22 by the target user, that is, a self-voice signal, is returned to the user, which is called the side tone.

Preferably, the side tone is transmitted to the earphone or speaker 21 of the target user within 40 ms (milliseconds) from the time the target user inputs the voice signal to the microphone 22. In addition, the signal processing includes a task of converting the pure voice signal S_O of the different user and the voice signal INT_OUT1 of the different user into signals having a shape or a size suitable for amplification by the two amplifiers ANC_Amp (L) and ANC_Amp (R) constituting the input/output amplification unit 130.

The Cable Connector 120 is connected to the intercom communication controller 10 by a wire (or communication line), and receives the voice signal INT_OUT1 of the different user through the intercom communication controller 10 or transmits the voice signal INT_IN1 of the target user to the intercom communication controller 10.

The MCU_Host_Control 150 controls the operations of the wireless transceiving unit 110, the Cable Connector 120, the input/output amplification unit 130, and the transmission path selection means 140. For example, the MCU_Host_Control 150 controls the operations of the communication module 111 constituting the wireless transceiving unit 110, the amplifier 133 that amplifies the user's voice signal, the transmission path selection means 140, and the Cable Connector 120.

The criteria for the operation control can be determined, for example, depending on whether the target user uses the wired/wireless transceiver 100 according to the present disclosure in a wired manner or a wireless manner, and depending on whether the target user presses a button for transmitting a voice signal.

When the target user uses the wired/wireless transceiver 100 according to the present disclosure in a wired manner, the MCU_Host_Control 150 can cause the communication module 111, the DSP 112, and the ADC 114 to remain in an inactive state, and cause the transmission path selection means 140 to transmit the voice signal INT_IN1 of the target user to the Cable Connector 120.

The MCU_Host_Control 150 can determine whether the target user is to use the wired/wireless transceiver 100 according to the present disclosure in a wired manner or a wireless manner, by monitoring whether the intercom communication controller 10 and the Cable Connector 120 are connected by a cable. That is, when the intercom communication controller 10 and the Cable Connector 120 are connected by a cable, unless there is a separate instruction from the target user, it can be determined that the target user uses the wired/wireless transceiver 100 according to the present disclosure in a wired manner, and if not, it can be determined that the target user uses the wired/wireless transceiver 100 according to the present disclosure in a wireless manner.

Although FIG. 2 illustrates one MCU_Host_Control 150, depending on the embodiment, separate controllers can be added so that one controller controls the operation of the wireless transceiving unit 110 and an additional separate controller controls the operation of the Cable Connector 120.

The Battery 160 may be manufactured and used in a replaceable form. However, when the target user uses the wired/wireless transceiver 100 according to the present disclosure in a wired manner, electric energy stored in the Battery 160 can be blocked from being transmitted to a corresponding function block and then charged, and when the target user uses the wired/wireless transceiver 100 according to the present disclosure in a wireless manner, the electric energy stored in the Battery 160 can be provided to the wireless transceiving unit 110, the input/output amplification unit 130, the transmission path selection means 140, and the MCU_Host_Control 150.

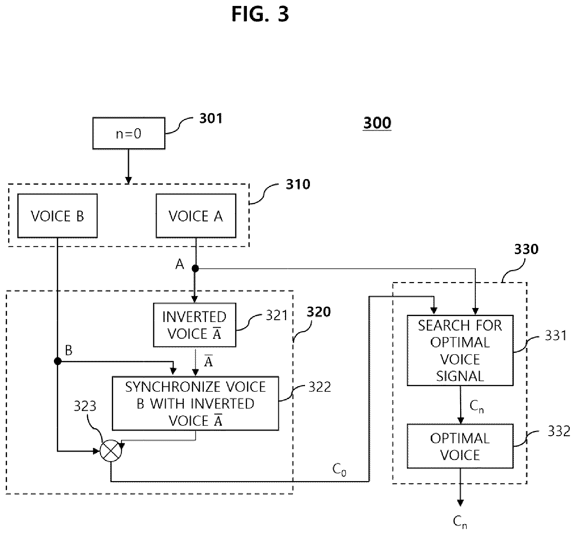

FIG. 3 illustrates a signal processing flow chart for performing a method 300 for line echo cancellation according to the present disclosure.

Referring to FIG. 3, the method 300 for line echo cancellation according to the present disclosure includes step 301 of defining a variable, step 310 of receiving a voice signal, step 320 of generating a first synthetic voice, and step 330 of deriving an optimal voice signal.

For convenience of description, the method 300 for line echo cancellation is described on the assumption that voice A means the voice signal of the target user and voice B means the voice signal of the different user. In particular, the voice B being the voice signal of the different user includes the voice A, which is the voice signal of the target user, in the actual voice signal of the different user (pure voice signal of the different user), and the method 300 for line echo cancellation according to the present disclosure relates to a technology for deriving the pure voice signal of the different user by cancelling the voice A of the target user from the voice B of the different user.

As described above, the wired/wireless transceiver 100 illustrated in FIG. 2 includes the wireless transceiving unit 110, and the wireless transceiving unit 110 includes the communication module 111, the DSP 112, the Audio CODEC 113, and the ADC 114.

The method 300 for line echo cancellation according to the present disclosure can be implemented through various devices, but for the purpose of facilitating understanding, an example, in which the method 300 for line echo cancellation is performed by the wireless transceiving unit 110, is described below.

In step 301 of defining the variable, a value of 0 (zero) is assigned to a variable n. The variable n is a positive integer including 0.

Step 310 of receiving the voice signal receives the voice B being the voice signal of the different user and the voice A being the voice signal of the target user, and transmits the received voice A and voice B to the DSP 112.

The communication module 111 receives the voice B being the voice signal of the different user, and transmits the received voice B to the DSP 112, and the voice A being the voice signal of the target user applied through the microphone 22 is converted into the digital signal by the ADC 114 and transmitted to the DSP 112.

Step 320 of generating the first synthetic voice includes step 321 of generating a first synthetic voice C₀ by synthesizing an inverted voice **A̅,** in which the phase of the voice A being the voice signal of the target user is inverted, with the voice B being the voice signal of the different user and generating the inverted voice **A̅,** step 322 of delaying the inverted voice **A̅** to synchronize the delayed inverted voice A̅ with the voice B, and step 323 of generating the first synthetic voice C₀ by synthesizing the delayed inverted voice **A̅** with the voice B.

As described above, the voice B includes the voice A being the voice signal of the target user, in addition to the voice signal of the different user, and accordingly, in an ideal case, when synthesizing the inverted voice **A̅,** in which the phase of the voice signal of the target user is inverted in the voice B, the voice A of the target user included in the synthesized first synthetic voice C₀ is cancelled by the inverted voice A̅**.**

However, since the time when the voice A of the target user is included in the voice B is a certain amount of time after the target user actually generates the voice A, as described above, the time of the inverted voice **A̅** is delayed in order to match the phase of voice A with the phase of voice B, and the delayed inverted voice **A̅** and the voice B are synthesized to generate the first synthetic signal C₀.

Step 330 of deriving the optimal voice signal includes step 331 of deriving a boundary value B by comparing the first synthetic voice C₀ with the voice A, deriving the optimal voice signal by sequentially generating a plurality of synthesized voices Cₙ (n is a natural number of 1 or more) until the derived boundary value is a preset optimal boundary value, and searching for the optimal voice signal, and step 332 of outputting the optimal voice signal.

Step 332 of outputting the optimal voice signal outputs the optimal voice signal Cₙ determined in step 331 of searching for the optimal voice signal.

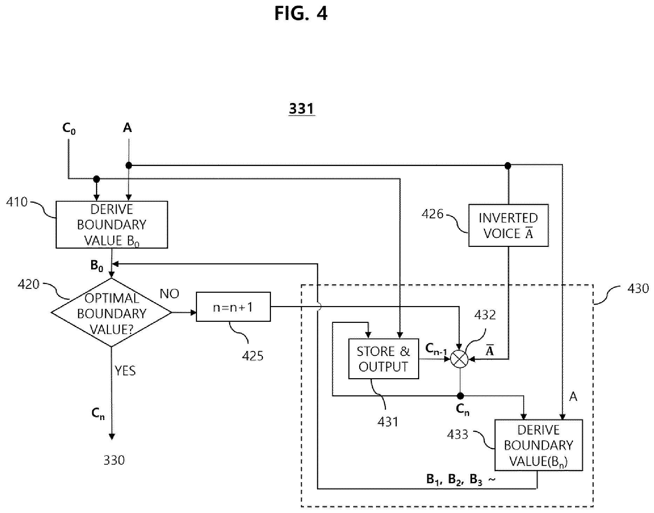

FIG. 4 illustrates a specific embodiment of the step of searching for the optimal voice signal.

Referring to FIG. 4, step 331 of searching for the optimal voice signal includes step 410 of deriving a first boundary value, step 420 of determining whether the derived boundary value is an optimal boundary value, step 425 of increasing the size of a variable, step 426 of generating the inverted voice **A̅,** and step 430 of generating an n^{th} boundary value.

Step 410 of deriving the first boundary value derives a first boundary value B₀ by comparing the first synthetic voice C₀ and the voice A, which are calculated in a state where the variable n is 0. The boundary value of the two signals C₀ and A is a cross correlation coefficient when the morphological similarity of the two signals C₀ and A is calculated using a cross correlation technique.

When a function obtained by delaying a function g(t) by time τ with respect to a function h(t), multiplying the two functions, and then integrating the multiplication result from -∞ to +∞ is a cross-correlation function, a cross-correlation coefficient is obtained by dividing the cross-correlation function by a square root of the product of the total energy of the two functions. The cross-correlation coefficient has a value between -1 and +1, and when the value is +1, it means that two time series are completely identical, and when the value is -1, it means that shapes are the same but phases are reversed. When the value is 0, it means that there is no similarity at all between the two time series. A statistical series is a series that organizes a certain amount of observation results according to a certain criterion, and a time series means a statistical series when a change in a certain observation value or statistical quantity is captured according to the movement of time and serialized.

Accordingly, an optimal boundary value to be described below is a preset value among 0 or values close to 0.

Step 420 of determining whether the derived boundary value is the optimal boundary value determines whether the first boundary value B₀ derived in step 410 of deriving the first boundary value is identical to a preset optimal boundary value. When it is determined (YES in 420) that the derived first boundary value B₀ is identical to the optimal boundary value, the first synthetic voice C₀ is output as the optimal voice signal.

Step 425 of increasing the size of the variable increases the value of the variable n by 1 (one) when it is determined (NO in 420) that the derived boundary value is not the optimal boundary value. When it is determined (NO in 420) that the first boundary value B₀ generated using the first synthetic voice C₀ is not identical to the optimal boundary value, n has a value of 1.

Step 426 of generating the inverted voice **A̅** generates the inverted voice A̅ in which the phase of the voice A of the target user is inverted.

Step 430 of generating the n^{th} boundary value is performed in a state (425) where the value of the variable n is increased by 1, the second synthetic voice C₁ is generated by additionally synthesizing the inverted voice **A̅** with the first synthetic voice C₀, and the second boundary value B₁ is derived by comparing the second synthetic voice C₁ with the voice A. Subsequently, step 420 is performed to determine whether the derived second boundary value B₁ is the optimal boundary value.

When it is determined (NO in 420) that the derived second boundary value B₁ is not the optimal boundary value, a third synthetic voice C₂ is generated by synthesizing the second synthetic voice C₁ with the inverted voice **A̅** (432), a third boundary value B₂ is derived by comparing the third synthetic voice C₂ with the voice A (433), step 420 is performed to determine whether the third boundary value B₂ is the optimal boundary value, and a new synthetic voice and a new boundary value are sequentially generated until an optimal boundary value is found among a plurality of boundary values continuously generated.

In order to perform the above process, step 430 of generating the n^{th} boundary value includes step 431 of storing and outputting a synthetic voice, step 432 of generating a synthetic voice, and step 433 of deriving a boundary value.

Step 431 of storing and outputting the synthetic voice receives and stores the first synthetic voice C₀ and an n^{th} synthetic voice Cₙ generated in step 432 of generating a synthetic voice to be described below, and outputs a corresponding synthetic voice Cₙ₋₁ among the plurality of stored synthetic voices according to the variable n. For example, since the value of the variable n has changed from 0 to 1, the synthetic voice C₀ is output, and when the value of the variable n is 2, the synthetic voice C₁ is output.

Step 432 of generating the synthetic voice generates a new synthetic signal Cₙ by synthesizing the inverted voice **A̅** of the target user with the voice signal Cₙ₋₁ output in step 432 of storing and outputting the synthetic voice. Since the variable n has changed to 1, the voice signal C₀ is output in step 432 of storing and outputting the synthetic voice.

Step 433 of deriving the boundary value generates the boundary value Bₙ by comparing the synthetic signal Cₙ generated in step 432 of generating the synthetic voice with the voice A of the target user, and step 420 is performed to determine whether the generated boundary value Bₙ is the optimal boundary value, so that it is determined whether the boundary value Bₙ is the optimal boundary value.

In a case (YES in 420) where the boundary value B₀ derived when the variable n is 0 (zero) is the optimal boundary value, the optimal voice signal output in step 333 of outputting the optimal voice signal is C₀, and in a case (YES in 420) where the boundary value B₁ derived when the variable n is 1 is the optimal boundary value, the optimal voice signal output in step 333 of outputting the optimal voice signal is C₁. When this is logically extended, in a case (YES in 420) where the boundary value B₀ derived when n is n is the optimal boundary value, it can be easily understood that the optimal voice signal output in step 333 of outputting the optimal voice signal is Cₙ.

The optimal voice signal output in step 332 of outputting the optimal voice signal includes only an actual voice signal of the different user, and in the description of FIG. 2, the optimal voice signal is named the pure voice signal S_O of the different user.

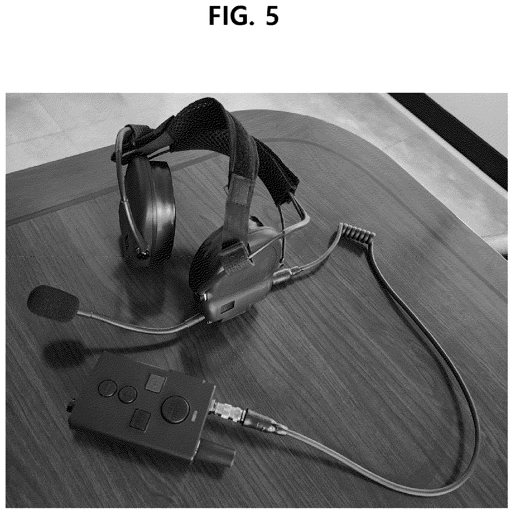

FIG. 5 illustrates a photograph of a product in which the wired/wireless transceiver according to the present disclosure is actually applied to a headset.

Referring to FIG. 5, it can be seen that the voice signal input/output device 20 can be mounted on a headphone and the wired/wireless transceiver 100 according to the present disclosure can be implemented as a separate device. The target user can wear the headphone 20 on his/her head and use the wired/wireless transceiver 100 connected to the headphone 20 by wire while carrying the wired/wireless transceiver 100.

The above technical idea of the present disclosure has been described with the accompanying drawings, but this is an example of a preferred embodiment of the present disclosure and does not limit the present disclosure. In addition, it is clear that any skilled in the art to which the present disclosure pertains can make various modifications and imitations within the scope without deviating from the scope of the technical idea of the present disclosure.

## Claims

1. A wired/wireless transceiver that is connected to an intercom communication controller in a wireless manner and connected to a voice signal input/output device in a wired manner, transmits/receives voice signals of a target user and a different user between the intercom communication controller and the voice signal input/output device, generates a side tone corresponding to the voice signal of the target user applied to the voice signal input/output device, transmits the generated side tone to the voice signal input/output device, cancels a line echo component included in the voice signal of the different user applied from the intercom communication controller and caused by the voice signal of the target user, and outputs the signal with no line echo component to the voice signal input/output device.

2. The wired/wireless transceiver of claim 1 comprises:
a wireless transceiving unit configured to generate the side tone and a pure voice signal of the different user by using the voice signal of the different user applied through the intercom communication controller and the voice signal of the target user applied through the voice signal input/output device, to process the voice signal of the target user, and to transmit the processed signal to the intercom communication controller;
a wired transceiving unit connected to the intercom communication controller in a wired manner and configured to receive the voice signal of the different user through the intercom communication controller, to transmit the received voice signal of the different user to the wireless transceiving unit or to transmit the voice signal of the target user to the intercom communication controller;
a transmission path selection means configured to select one of the wireless transceiving unit and the wired transceiving unit and transmit the voice signal of the target user to the selected transceiving unit;
a controller configured to control operations of the wireless transceiving unit, the wired transceiving unit, and the transmission path selection means.

3. The wired/wireless transceiver of claim 2 further comprises:
an input/output amplification unit configured to receive and amplify the side tone and the pure voice signal of the different user output from the wireless transceiving unit, and to amplify the voice signal of the target user.

4. The wired/wireless transceiver of claim 3,
Wherein the wireless transceiving unit comprises:
a communication module configured to perform wireless communication with the intercom communication controller, and to receive the voice signal of the different user or transmit the voice signal of the target user to the intercom communication controller;
an ADC configured to convert the voice signal of the target user applied through the transmission path selection means into a digital signal;
a digital signal processing device configured to process the voice signal of the target user output from the ADC to transmit the processed signal to the communication module, or generate the pure voice signal of the different user, from which the line echo component included in the voice signal of the different user has been cancelled, by using the voice signal of the different user applied through the communication module and the voice signal of the target user output from the ADC; and
an audio codec configured to generate the side tone by using the voice signal of the target user applied through the transmission path selection means to transmit the side tone to the input/output amplification unit, or to process the pure voice signal of the different user and the voice signal of the different user applied through the wired transceiving unit and transmit the processed signal to the input/output amplification unit.

5. The wired/wireless transceiver of claim 4,
Wherein the the digital signal processing device receives the voice signals of the different user and the target user, generates a first synthetic voice by synthesizing an inverted voice **A̅,** in which a phase of voice A being the voice signal of the target user is inverted, with voice B being the voice signal of the different user, derives a boundary value by comparing the first synthetic voice with the voice A, generates a plurality of synthetic voices by adding the inverted voice **A̅** to the first synthetic voice and accumulating the added voice, derives a plurality of boundary values by comparing the plurality of synthetic voices with the voice A, respectively, and derives an optimal voice signal by performing the generation of the synthetic voice and the derivation of the boundary value until the derived boundary value is identical to an optimal boundary value specified in advance.

6. The wired/wireless transceiver of claim 1, wherein the input/output amplification unit comprises:
two amplifiers configured to receive and amplify the side tone of the target user and the pure voice signal of the target user that are output from the wireless transceiving unit; and
one amplifier configured to amplify the voice signal of the target user.

7. The wired/wireless transceiver of claim 1, wherein the controller determines whether the wired/wireless transceiver operates in a wireless manner or a wired manner according to whether the intercom communication controller and the wired transceiving unit are connected by a cable.

8. The wired/wireless transceiver of claim 7, wherein, when the wired/wireless transceiver operates in a wired manner, the controller deactivates operations of the communication module, the digital signal processing device, and the ADC, and controls the transmission path selection means to transmit the voice signal of the target user to the wired transceiving unit, and
when the wired/wireless transceiver operates in a wireless manner, the controller controls the transmission path selection means to transmit the voice signal of the target user to the wireless transceiving unit.

9. The wired/wireless transceiver of claim 1, wherein the wired/wireless transceiver is connected to the intercom communication controller and the voice signal input/output device in a wireless manner.

10. A method for line echo cancellation comprising:
receiving voice signals of a different user and a target user;
generating a first synthetic voice by synthesizing an inverted voice **A̅,** in which a phase of voice A being the voice signal of the target user is inverted, with voice B being the voice signal of the different user;
deriving a boundary value by comparing the first synthetic voice with the voice A, generating a plurality of synthetic voices by adding the inverted voice **A̅** to the first synthetic voice and accumulating the added voice, deriving a plurality of boundary values by comparing the plurality of synthetic voices with the voice A, respectively, and deriving an optimal voice signal by performing the generation of the synthetic voice and the derivation of the boundary value until the derived boundary value is identical to an optimal boundary value specified in advance.

11. The method for line echo cancellation of claim 10, wherein the boundary value is a cross correlation coefficient when a morphological similarity of two signals to be compared is calculated using a cross correlation technique.

12. The method for line echo cancellation of claim 11, wherein the generating of the first synthetic voice comprises:
generating the inverted voice **A̅** by inverting the phase of the voice A;
synchronizing the inverted voice **A̅** with the voice B by delaying the inverted voice **A̅;** and
generating the first synthetic voice by synchronizing the delayed inverted voice **A̅** with the voice B.

13. The method for line echo cancellation of claim 11, wherein the deriving of the optimal voice signal comprises:
deriving a first boundary value by comparing the first synthetic voice and the voice A calculated in a state where a variable is 0;
determining whether the first boundary value is identical to the optimal boundary value specified in advance;
increasing the variable by 1 when it is determined in the determining that the first boundary value is not identical to the optimal boundary value;
generating the inverted voice **A̅** in which the phase of the voice A of the target user is inverted;
after the increasing of the variable by 1, generating a second synthetic voice by additionally adding the inverted voice **A̅** with the first synthetic voice and deriving a second boundary value by comparing the second synthetic voice with the voice A; and
determining whether the second boundary value is identical to the optimal boundary value.

14. The method for line echo cancellation of claim 13, wherein, when it is determined that the first boundary value is identical to the optimal boundary value specified in advance, the first synthetic voice is set as the optimal voice signal, and
when it is determined that the second boundary value is identical to the optimal boundary value specified in advance, the second synthetic voice is set as the optimal voice signal.
